(19) Europäisches Patentamt
European Patent Office
Office européen des brevets

(11) **EP 1 548 934 B1**

(12) **EUROPÄISCHE PATENTSCHRIFT**

(45) Veröffentlichungstag und Bekanntmachung des Hinweises auf die Patenterteilung:
**03.09.2008 Patentblatt 2008/36**

(51) Int Cl.:
*H03F 5/00* (2006.01)   *H03F 3/26* (2006.01)
*H03F 1/32* (2006.01)

(21) Anmeldenummer: **04030390.1**

(22) Anmeldetag: **22.12.2004**

(54) **Vollsymmetrischer Leistungsverstärker**

Fully differential push-pull amplifier

Amplificateur push-pull totalement différentiel

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **22.12.2003 DE 10360347**

(43) Veröffentlichungstag der Anmeldung:
**29.06.2005 Patentblatt 2005/26**

(73) Patentinhaber: **Blöhbaum, Frank**
**79112 Freiburg i.Br. (DE)**

(72) Erfinder: **Blöhbaum, Frank**
**79112 Freiburg i.Br. (DE)**

(56) Entgegenhaltungen:
WO-A-00/11779          FR-A- 2 547 470
US-A- 4 229 706        US-A- 4 531 100
US-B1- 6 242 977

**Beschreibung**

Die wesentlichen Qualitätskriterien für Leistungsverstärker, insbesondere bei Anwendungen im Audiobereich, sind ein möglichst geringer Klirrfaktor, eine hohe Bandbreite, ein möglichst geringer Innenwiderstand, möglichst geringe transiente Intermodulationsverzerrungen und eine hohe Arbeitspunktstabilität der Leistungsbauelemente.

Leistungsverstärker können mit sehr unterschiedlichen aktiven Bauelementen aufgebaut werden, deren Eigenschaften in der Regel die Struktur des Verstärkers bestimmen: Röhren mit unterschiedlichem Aufbau, z.B. Trioden, Tetroden, Pentoden, oder Halbleiterbauelemente, z.B. Bipolartransistoren, Feldeffekttransistoren, MOSFETs und IGBTs. Röhren haben für den Einsatz als Leistungsverstärker in der Regel einen vergleichsweise hohen Innenwiderstand und müssen deshalb mit Hilfe von speziell aufgebauten Transformatoren, den Übertragern, an die niedrige Impedanz des Lautsprechers angepasst werden. Diese Übertrager begrenzen indessen die erzielbare Bandbreite und sind selbst Quelle erheblicher nichtlinearer Verzerrungen. Die deshalb wünschenswerte direkte Ankopplung der in der Regel niederohmigen Last des Lautsprechers erfordert die Verwendung von aktiven Bauelementen mit möglichst geringem Innenwiderstand bzw. möglichst großer Steilheit. Aus diesem Grund hat sich als Stand der Technik die Verwendung von Halbleiterbauelementen wie Bipolartransistoren, MOSFETs oder in selteneren Fällen auch IGBTs durchgesetzt.

Besonders häufig werden Verstärker mit höheren Leistungsanforderungen als komplementäre Gegentaktverstärker realisiert, wobei komplementäre Bipolartransistoren (npn- und pnp-Transistor) oder komplementäre MOSFETs (n-Kanal- und p-Kanal-Transistor) oder komplementäre IGBTs (n-Kanal- und p-Kanal-Typ) mit einer auf Massepotential bezogenen bipolaren oder unipolaren Betriebsspannungsquelle eingesetzt werden.

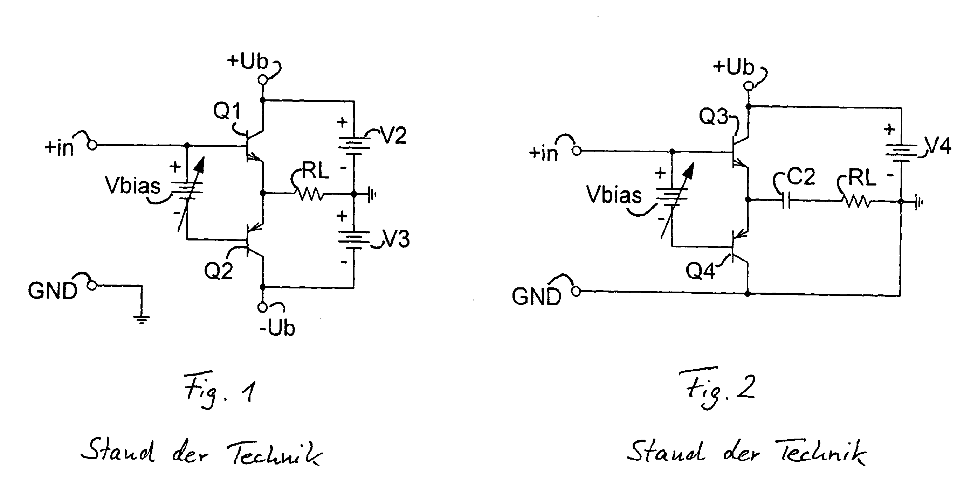

Das gemeinsame Merkmal des in Fig. 1 und Fig. 2 dargestellten Prinzips eines typischen halbleiterbestückten Gegentaktverstärkers oder einer entsprechenden Gegentaktendstufe ist die Verwendung eines komplementären Transistorpaares. Zur Ruhestromeinstellung über das komplementäre Transistorpaar dient eine einstellbare Vorspannungsquelle, die zwischen den beiden Basisanschlüssen des komplementären Transistorpaares liegt. Die weiteren Schaltungsteile sind dann zueinander unterschiedlich.

In der Grundschaltung von Fig. 1 werden im Leistungsteil mindestens zwei in Reihe geschaltete Spannungsquellen verwendet, deren Verbindungspunkt an Masse gelegt ist, so dass sich bezogen auf das Massepotential eine positive und eine negative Versorgungsspannung ergibt. Das Ansteuersignal ist ein auf Massepotential bezogenes symmetrisches Signal. Die Last, z.B. der Lautsprecher, liegt zwischen dem Verbindungspunkt des komplementären Transistorpaares und dem Masseanschluss.

In der Grundschaltung von Fig. 2 wird im Leistungsteil nur eine einzige Spannungsquelle mit einseitigem Masseanschluss verwendet. Das Ansteuersignal ist ein auf Massepotential bezogenes unipolares Signal. Wenn die Last einen Gleichstrompfad aufweist, muss sie kapazitiv von den auf unterschiedlichen Pegeln liegenden Ausgangsklemmen, die durch den Verbindungspunkt des komplementären Transistorpaares und den Masseanschluss gebildet sind, getrennt werden.

Am zuletzt genannten Merkmal ändert sich auch nichts wesentliches durch das Einfügen eines sehr niederohmigen Messwiderstandes zwischen dem Lastwiderstand bzw. dem Lautsprecher und der Masse, wie dies in einigen Publikationen zur Strommessung vorgeschlagen wird.

Komplementäre Gegentaktendstufen mit Röhren gibt es nicht, da Röhren entsprechend dem Elektronenfluss zwischen Kathode und Anode nur einen negativen Strom steuern, so dass ein zur Elektronenröhre komplementäres Verstärkerelement fehlt.

Für die Realisierung hochlinearer Leistungsverstärker wäre der Einsatz von Röhren als Spannungsverstärker jedoch sehr wünschenswert, da in diesem Anwendungsfall Röhren wegen ihrer quadratischen Strom-Spannungskennline sehr verzerrungsarm betrieben werden können. Optimal wäre die Kombination von Röhren als Spannungsverstärker mit hochsteilen Halbleiterbauelementen, wie Bipolartransistoren, MOSFETs oder IGBTs, als ausgangsseitiger Leistungsverstärker. Von großem Vorteil wäre hierbei eine Gleichstromkopplung zwischen den einzelnen Verstärkungsstufen, damit die ansonsten für die Potentialtrennung erforderlichen Kopplungs- oder Überbrückungskondensatoren oder Übertrager keinen schädlichen Einfluss auf den Frequenzgang oder den Klirrfaktor haben.

Die bisherigen Entwicklungen konzentrieren sich auf die Optimierung von reinen Transistorverstärkern einerseits und reinen Röhrenverstärkern andererseits. Daneben sind auch vereinzelt Verstärker mit hybrider Bauelementebestückung bekannt, die getrennt nach Röhren- bzw. Transistorverwendung optimierte Vor- und Leistungsverstärker enthalten, die in der Regel kapazitiv miteinander gekoppelt sind.

Bei den komplementären Gegentaktendstufen gemäß Fig. 1 mit den beiden auf Massepotential bezogenen Spannungsquellen entgegengesetzter Polarität führt die Verwendung von komplementären aktiven Bauelementen im Leistungsteil zwangsläufig zu einer inhärent nichtsymmetrischen Struktur. So sind beide Zweige des im Gegentakt arbeitenden Verstärkers nicht mit den gleichen Bauelementen aufgebaut und damit prinzipiell nur bedingt symmetrisch. Die volle elektronische Symmetrie würde erfordern, dass bis auf den Leitungstyp alle elektronischen Eigenschaften des npn- und pnp-Transistors einander gleich sind. Das ist natürlich nur näherungsweise erreichbar. Die Unterschiede stören das Symmetrieverhalten der Verstärkung in den beiden Signalpfaden und erschweren u.a. die Realisierung weiterer verzerrungsmindernder Schaltungsstrukturen.

Ein Problem bei der Suche nach einem möglichst symmetrischen komplementären Transistorpaar ist die sehr begrenzte Auswahl an pnp-Bipolartransistoren, p-Kanal-MOSFETs und p-Kanal-IGBTs für hochwertige Leistungsverstärker. Dieses Problem wird durch den Aufbau einer quasikomplementären Leistungsstufe nicht behoben, sondern auf Kosten der Symmetrie nur in die Treiberstufe verlagert. Die in der Realität verwendbaren Paare komplementärer Transistoren sind bei näherer Analyse keineswegs echte Paare. So unterscheiden sich die komplementären Transistoren eines Komplementärpaares zum Beispiel maßgeblich hinsichtlich des Betrages des Stromverstärkungsfaktors bei Bipolartransistoren bzw. der Steilheit bei MOSFETs und IGBTs. Dies ist eine wesentliche Ursache für Nichtlinearitäten im Verstärkerverhalten.

Beispielsweise ist bei gleicher Drain-Source-Spannungsfestigkeit, gleichem zulässigen maximalen Drainstrom sowie gleicher maximal zulässiger Verlustleistung die Chipgröße von p-Kanal-MOSFETs ca. dreimal größer als die Chipfläche des komplementären n-Kanal-MOSFETs. Das führt zwangsläufig zu erheblich unterschiedlichen Kapazitäten, insbesondere der Gate-Source-Kapazität und der Drain-Source-Kapazität. Durch die unterschiedlichen kapazitiven Lasten resultieren Probleme bei der Ansteuerung und ohne weitere Schaltungsmaßnahmen ergeben sich unterschiedliche Flankensteilheiten (= Slew-Rate) für positive und negative Flanken am Verstärkerausgang. Wird ein solcher Verstärker gegengekoppelt, wird die Frequenzkompensation von den erheblich größeren Kapazitäten des negativen Zweiges (p-Kanal MOSFETs bzw. -IGBTs) bestimmt. Das kann die erreichbare Leistungsbandbreite unzulässig stark reduzieren oder zu Instabilitäten führen. Bei Bipolartransistoren sind diese Anpassprobleme (=Matching-Probleme), die für die komplementäre Symmetrie erforderlich sind, ähnlich.

Zusammenfassend ist festzustellen, dass die dem Stand der Technik entsprechenden Gegentaktverstärker in Komplementärtechnik prinzipbedingt keine vollständige Symmetrie erreichen können. Es sind einige Verfahren bekannt, welche die daraus resultierenden Nichtlinearitäten mittels einer Gegenkopplung und/oder einer Vorwärtsfehlerkompensation (= Forward-Error-Correction) zu beheben versuchen. Der dafür notwendige Schaltungsaufwand ist für hochqualitative Leistungsverstärker allerdings sehr hoch. Desweiteren ist die korrekte Arbeitsweise der Fehlerkompensation bei der für Audio-Anwendungen typischen Ansteuerung mit transienten Impulsen kritisch. So ist beispielsweise in der US Patentanmeldung US 5,892,398 ein Leistungsverstärker beschrieben, der vom Ausgangssignal gesteuerte Betriebsspannungen nach dem Bootstrap-Prinzip für die Kompensationsbaugruppe verwendet, deren hochlineare Erzeugung wiederum schwierig ist. Der für Audio-Leistungsverstärker typische Fall der Ansteuerung komplexer, auch kapazitiver Lasten wie Lautsprecher und Frequenzweichen unterschiedlichster Bauart, erfordert eine hohe Stabilität im gegengekoppelten Zustand, die mit herkömmlichen komplementären Gegentaktendstufen auf Grund der unterschiedlichen Hochfrequenzeigenschaften beider Signalpfade nur eingeschränkt erreichbar ist.

Übertragerlose Gegentaktleistungsverstärker, die aktive Bauteile nur eines Leitfähigkeitstyps verwenden und die damit streng symmetrisch bezüglich der elektrischen Eigenschaften realisierbar sind, wurden bislang insbesondere mit Röhren auf den Markt gebracht. Sie werden allgemein als OTL-Verstärker bezeichnet (= Output Transformer-Less) und unter dieser Bezeichnung kommerziell angeboten. Röhrenverstärker, die nach diesem Prinzip gebaut sind, weisen folgende grundsätzlichen Nachteile auf: Röhren haben eine zu geringe Steilheit, um die niederohmige Impedanz des Lastwiderstandes bzw. des Lautsprecher direkt anzusteuern. Ohne weitere Schaltungsmaßnahmen resultieren hieraus eine geringe abgebbare Leistung und ein sehr hoher Klirrfaktor.

Um die Steilheit zu erhöhen, werden viele Röhrensysteme parallel geschaltet. Damit lässt sich bei exzessiv parallel geschalteten Röhren bzw. Röhrensystemen die Steilheit des daraus resultierenden Leistungsbauelementes auf einen gerade ausreichenden Wert erhöhen. Der Klirrfaktor bleibt aber immer noch hoch. Es gibt nun aber erhebliche Probleme mit der Stabilität der Arbeitspunkte der vielen Röhrensysteme. Die thermische Drift des Anodenstromes bei vorgegebener Gittervorspannung und die Änderung der Röhreneigenschaften infolge von Alterung, wie z.b. nachlassende Katodenemissionsfähigkeit, führen im günstigsten Fall zu einem erhöhten Klirrfaktor, im ungünstigsten Fall zum Totalausfall des Gerätes.

Der Arbeitspunkt der Leistungsstufe wird bei diesen Röhrenschaltungen mittels einer festen Gittervorspannung wie beispielsweise im US-Patent 4,719,431 oder durch je einen Katodenwiderstand eingestellt. Die zugehörige Vorstufe bzw. der Spannungsverstärker wird kapazitiv angekoppelt. Beispiele hierfür zeigen die US-Patente US 4,719,431 in Fig. 4 und US 6,242,977 B1 in Fig.2. Eine Gleichspannungskopplung ist nach dem Stand der Technik nur indirekt mittels eines hochohmigen Spannungsteilers möglich, der wiederum kapazitiv überbrückt werden muss. Ohne diesen Überbrückungskondensator wäre der Wechselspannungsabfall viel zu groß. Andererseits würde eine direkte Gleichspannungskopplung den ohnehin schon stark driftgefährdeten Arbeitspunkt der Endröhre oder der parallelgeschalteten Endröhren weiter destabilisieren, da sich dann die Drift der Vorröhre multipliziert mit dem DC-Verstärkungsfaktor der Endröhre (n) zusätzlich auswirken würde.

Die nach dem Stand der Technik in Röhrenschaltungen unausweichliche Verwendung von Koppel- und/oder Überbrückungskondensatoren verschlechtern die erreichbare Linearität erheblich. Wie H. Lemme in der "Elektronik" Heft 10/2003, S. 90 - 94 mit dem Artikel "Kondensatoren als Störenfriede" nachweist, erhöhen insbesondere Kondensatoren mit hoher Gleichspannungsbelastung für hochqualitative Verstärker den Klirrfaktor auf unzulässig hohe Werte.

Im US-Patent US 4,229,706 ist ein gleichspannungsgekoppelter Gegentaktverstärker in Halbleitertechnik beschrieben, dessen Ausgangsstufen aus zwei identischen npn-Leistungstransistoren bestehen, die von zwei "schwebenden" Spannungsquellen gespeist sind. Die beiden Bipolartransistoren der Ausgangsstufe sind bezüglich ihres Lastausganges kreuzgekoppelt. Die Vorverstärkung erfolgt für jeden Signalpfad über jeweils eine Treiberschaltung mit Differenzeingang. An die beiden nichtinvertierenden Eingänge wird das zu verstärkende Signal als Differenzspannung angelegt. Die beiden invertierenden Eingänge sind über ein Widerstandsnetzwerk mit den beiden Lastanschlüssen und mit einem negativen Pol einer massebezogenen Vorspannungsquelle verbunden. Die Ausgänge der beiden Treiberschaltungen speisen jeweils direkt die Basis des zugehörigen Ausgangstransistors.

Die in US 4,229,706 beschriebene Anordnung ist zwar weitgehend symmetrisch und gleichspannungsgekoppelt, dies wird jedoch durch folgende Nachteile erkauft:

Die Art der realisierten Ruhestromeinstellung funktioniert ausschließlich mit Bipolartransistoren, da die Höhe des Basisstromes (Stromfluss der Basis-Emitterstrecke) über den Treiber und das Widerstandsnetzwerks gesteuert wird.

Die ausschließliche Ruhestromeinstellung über die Steuerung des Basisstromes funktioniert in kreuzgekoppelten Verstärkern nur unter Verwendung ideal gleicher bipolarer Leistungstransistoren. In der Realität wird die unvermeidliche Streuung des Stromverstärkungsfaktors absolut und in Abhängigkeit von der Temperatur zu erheblichen Abweichungen zwischen den Ruheströmen der beiden Leistungstransistoren führen. Damit entsteht ein nicht vertretbar hoher Differenzfehlstrom durch den Lastwiderstand des angeschlossenen Lautsprechers.

Darüber hinaus ist die ausschließliche Verwendung von Halbleiterbauelementen in der Schaltung nach dem US-Patent 4,229,706 auch deshalb ein Nachteil, da so die wünschenswerte Flexibilität des Designs stark eingeschränkt wird. So ist es beispielsweise äußerst schwierig, mit Röhren einen verzerrungsarmen Spannungsverstärker zu realisieren, der die hohen Basisströme der ausschliesslich einsetzbaren bipolaren Leistungstransistoren treiben kann. Wünschenswert wäre in diesem Fall der Einsatz von MOSFETs oder IGBTs als Leistungsbauelement, da diese Bauelemente spannungsgesteuert sind und damit eine Kombination mit verzerrungsarmen Spannungsverstärkern auf Röhrenbasis möglich wäre.

In US 6,242,977 B1 ist in Fig.4 ein Gegentaktverstärker mit MOSFETs nur eines Leitfähigkeitstyps ohne vorausgehenden Spannungsverstärker dargestellt, wobei die beiden MOSFETs über zwei "unechte" schwebende Spannungsquellen gespeist sind. Die beiden unechten schwebenden Spannungsquellen werden dabei mittels einer kapazitiven Entkopplung aus einer einzigen Spannungsquelle gebildet. Auch diese Schaltungsvariante hat für praktisch realisierbare hochqualitative Leistungsverstärker folgende Nachteile:

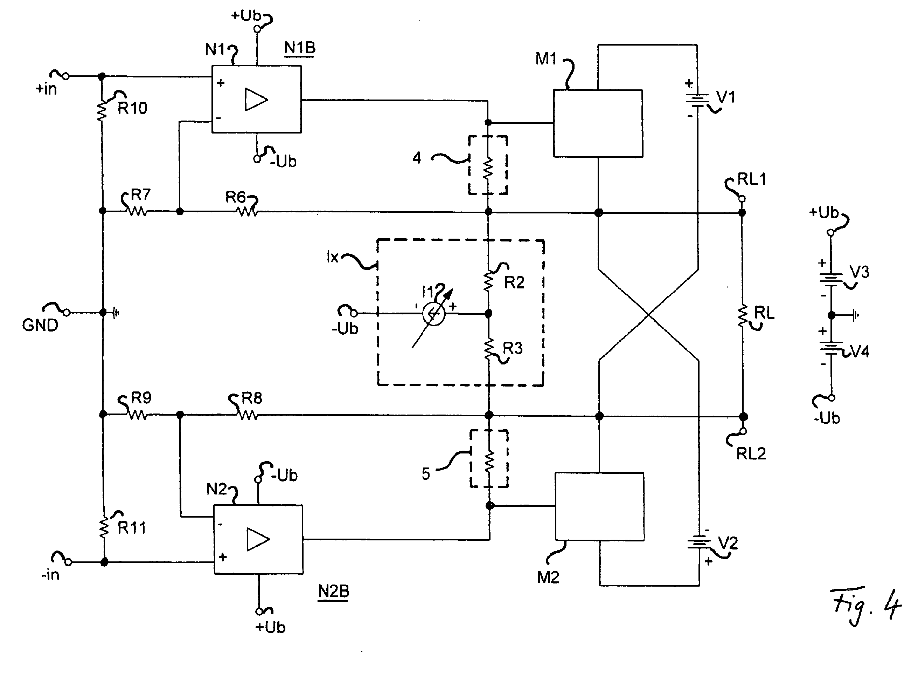

Der Arbeitspunkt der MOSFETs wird mittels einer fixen Gatespannung über einen Spannungsteiler einerseits (vgl. Fig. 4, Knoten 276, Widerstände 308 und 310) und eine Regelspannung (aus der Regleinrichtung 268) andererseits eingestellt. Die temperaturabhängige Änderung des Drainstromes bei konstanter Gate-Source-Spannung führt im ungünstigen Fall zu einer erheblichen Änderung des Absolutwertes des Drainstromes und kann schlimmstenfalls zur thermischen Zerstörung des MOSFETs führen. Die eingestellte DC-Gatespannung muss vom Ausgangspotential des stets vorgeschalteten aber in keinem der in US 6,242,977 B1 dargestellten Ausführungsbeispiele mittels eines Kondensators galvanisch getrennt werden. Damit wird die wünschenswerte Realisierung eines DC-gekoppelten Verstärkers ohne Koppelund/oder Überbrückungskondensatoren nicht möglich.

Die in Fig. 4 von US 6,242,977 B1 dargestellte Erzeugung der schwimmenden Betriebsspannungen aus einer einzigen Spannungsquelle ist für Leistungsverstärker problematisch, da die dort auftretenden, unter Umständen stark schwankenden, hohen Ströme kleine Entkopplungswiderstände 286, 288, 290 und 292 und in der Folge dann extrem große Kondensatoren 294 und 296 erfordern. Diese Kondensatoren entfallen, wenn für die beiden Leistungsverstärker jeweils eine echte schwebende Spannungsquelle wie beim angegebenen Stand der Technik in Fig. 1 von US 6,242,977 B1 vorgesehen ist.

Aufgabe der Erfindung ist die Angabe eines verbesserten Gegentaktverstärkers, der einen vollsymmetrischen Aufbau mit Funktionseinheiten gleichen Leitungstyps aufweist, möglichst große Freiheit für den Einsatz von Röhren und/oder Halbleitern und/oder monolithisch integrierten Schaltungen zulässt, einen transformatorlosen Anschluss der Last ermöglicht und auf Kopplungs- sowie Überbrückungskondensatoren und Übertrager verzichtet.

Die Lösung der Aufgabe erfolgt nach den Merkmalen des Anspruchs 1. Die Vorteile der Erfindung bestehen darin, dass durch die vorgeschlagenen Verbesserungen ein Leistungsverstärker mit sehr hoher Linearität, der vorzugsweise als Audioverstärker der höchsten Qualitätskategorie dient, realisiert wird. Die Arbeitspunkte sind auf einfache Weise einstellbar, wobei restliche Unsymmetrien der Funktionseinheiten über zusätzliche Regeleinrichtungen sicher stabilisierbar sind. Die Regeleinrichtungen können auch so ausgebildet werden, dass sie Änderungen durch Drift und Temperatur ausgleichen können. Durch die geforderte Flexibilität lassen sich für die Vorverstärkerblöcke und die Endverstärker jeweils die zweckmäßigsten Bauelemente verwenden und miteinander kombinieren. Ob der Leistungsverstärker grundsätzlich mit einem symmetrischen Differenzsignal um den Massebezugspegel angesteuert wird oder ob dem Differenzsignal ein Gleichpegel überlagert ist oder ob ein unipolares Ansteuersignal vorliegt, erfordert allenfalls geringfügige Änderungen in den beiden Signalpfaden oder in den Regeleinrichtungen.

Die Erfindung und vorteilhafte Ausgestaltungen und Weiterbildungen werden nun anhand der Figuren der Zeichnung näher erläutert:

Fig. 1 und Fig. 2 zeigen schematisch zwei bekannte Komplementärverstärker,
Fig. 3 zeigt schematisch einen bekannten Gegentaktverstärker mit identischen und DC-gekoppelten Funktionseinheiten und mit Kreuzkopplung in der Leistungsstufe,
Fig. 4 zeigt schematisch ein erstes Ausführungsbeispiel der Erfindung,
Fig. 5 zeigt schematisch ein Ausführungsbeispiel mit einer Offsetspannungsregelung,
Fig. 6 zeigt ein Ausführungsbeispiel mit einer erweiterten Offsetspannungsregelung,
Fig. 7 zeigt ein Ausführungsbeispiel mit Röhren in der Leistungsstufe,
Fig. 8 zeigt ein Ausführungsbeispiel mit einer geänderten Ruhestromeinstellung,
Fig. 9 zeigt ein Ausführungsbeispiel mit geänderten Eingangsanschlüssen,
Fig. 10 zeigt ein Ausführungsbeispiel mit Optokopplern zur Ruhestromeinstellung und
Fig. 11 zeigt ein Ausführungsbeispiel mit einem unsymmetrischen Signaleingang.

Der bekannte Komplementärverstärker von Fig. 1 enthält in Reihenschaltung einen npn-Transistor Q1 und einen pnp-Transistor Q2 zwischen zwei Spannungsanschlüssen +Ub und -Ub, die von zwei in Reihe geschalteten Spannungsquellen V2, V3 gespeist sind. Der Verbindungsknoten dieser Spannungsquellen ist mit dem Massepotential GND verbunden und mit einem Anschluss der Last RL. Der andere Anschluss dieser Last RL liegt am Verbindungsknoten der beiden Transistoren Q1, Q2. Für die Ruhestromeinstellung der beiden Transistoren Q1, Q2 sorgt eine einstellbare Vorspannungsquelle Vbias zwischen den beiden Basen dieser Transistoren. Durch geeignete Einstellung der Vorspannung Vbias lässt sich der Ruhestrom der beiden Transistoren so einstellen, dass sie z.B. jeweils im AB-Verstärkungsbetrieb arbeiten. Die unsymmetrische Eingangsspannung wird über einen Eingang +in der Basis des npn-Transistors zugeführt. Der Komplementärverstärker ist bezüglich des masseabgewandten Lastanschlusses nichtinvertierend. Kondensatoren zur Potentialtrennung sind in Fig. 1 nicht dargestellt. Sie sind jedenfalls dann erforderlich, wenn dem Eingangssignal eine Gleichspannung überlagert ist und der Eingangsspannungshub nicht sehr groß gegenüber der Basis-Emitterspannung von Transistor Q1 ist.

Der bekannte Komplementärverstärker nach Fig. 2 erfordert im Unterschied zu Fig. 1 nur eine Spannungsquelle V4 für die beiden in Reihe geschalteten Komplementärtransistoren Q3, Q4 aus einem npn- und einem pnp-Transistor, die zwischen einem positiven Versorgungsanschluss +Ub und dem Masseanschluss GND liegen. Die Spannungsquelle V4 liegt mit ihrem einen Anschluß an Masse GND und speist mit dem anderen den Versorgungsanschluss +Ub. Die Ruhestromeinstellung für die beiden Transistoren erfolgt wie in Fig. 1 über eine einstellbare Vorspannungsquelle Vbias, die zwischen den beiden Basisanschlüssen liegt. Da der gemeinsame Emitteranschluss bei dieser Komplementärschaltung auch näherungsweise nicht mehr auf dem Massepotential GND liegt, gibt es im Ruhezustand eine Spannungsdifferenz zwischen dem gemeinsamen Emitteranschluss und der Masse GND, die etwa der halben Versorgungsspannung V4 entspricht. Die zwischen diesen beiden Knoten anzuschließende Last RL muss, falls sie einen Gleichstrompfad aufweist, daher von dieser Gleichspannung durch einen Koppelkondensator C2 getrennt werden. Zusätzlich zu diesem Koppelkondensator C2 muss der Signaleingang +in ebenfalls durch einen Kondensator spannungsmäßig von der Signalquelle getrennt werden, da der Signaleingang +in etwa ebenfalls die halbe Versorgungsspannung V4 aufweist und damit in der Regel sich sehr vom Ruhepotential der Signalquelle unterscheidet.

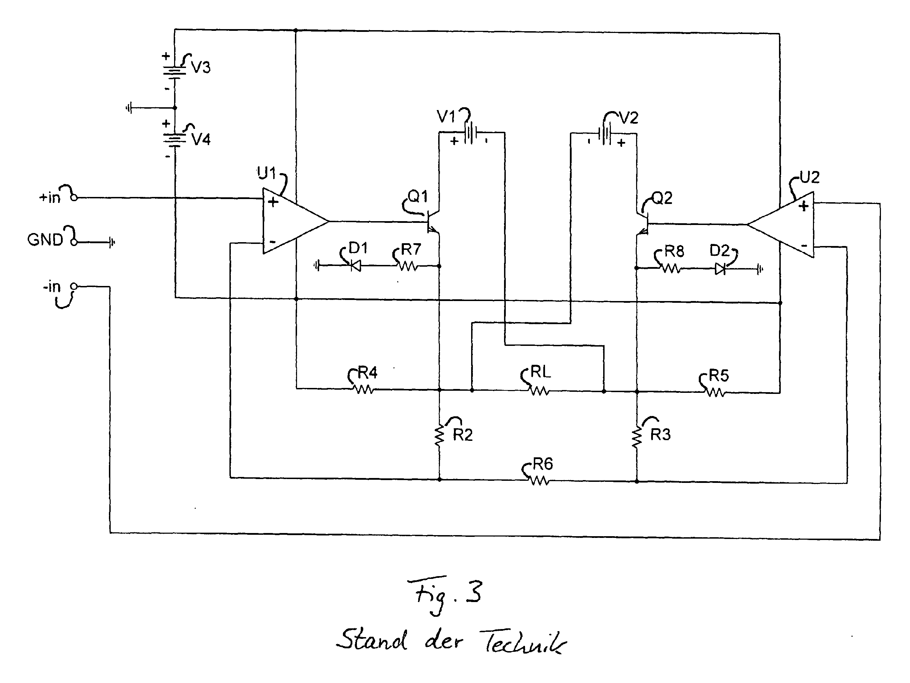

Fig. 3 zeigt den im bereits erwähnten US-Patent US 4,229,706 beschriebenen Audiogegentaktverstärker mit symmetrischem Aufbau, der in den beiden Signalpfaden DC-gekoppelt ist und dessen beide npn-Endstufentransistoren Q1, Q2 jeweils von einer schwimmenden Spannungsversorgung V1, V2 gespeist sind. Die galvanische Trennung von dem Massebezugspotential GND wird bei der schwimmenden Spannungsversorgung in der Regel mittels eines eigenen Netztransformators und einer Brückengleichrichterschaltung erreicht. Die Last RL ist zwischen den beiden Emittern angeschlossen, die auch die Fußpunkte für die über Kreuz angeschlossenen schwimmenden Versorgungsspannungen V1, V2 bilden. Das symmetrische Eingangssignal wird über die Eingänge +in und -in zugeführt, wobei der positive Eingang +in mit dem nichtinvertierenden Eingang eines in Bipolartechnik ausgeführten Operationsverstärkers U1 verbunden ist. Der negative Eingang -in ist mit dem nichtinvertierenden Eingang eines zum ersten Operationsverstärker U1 identischen zweiten Operationsverstärker U2 verbunden. Der Ausgang des ersten bzw. zweiten Operationsverstärkers ist direkt, also ohne Koppelkondensator, mit der Basis des ersten bzw. zweiten Ausgangstransistors Q1, Q2 verbunden. Die Spannungsversorgung der beiden Operationsverstärker erfolgt über zwei in Reihe geschaltete Spannungsquellen V3, V4, deren Verknüpfungspunkt an das Massepotential GND angeschlossen ist und deren masseabgewandte Pole die positive und negative Versorgungsspannung +V, -V für die beiden Operationsverstärker U1, U2 bilden.

Die Ruhestromeinstellung der beiden Ausgangstransistoren Q1, Q2 erfolgt über jeweils einen Widerstand R4 bzw. R5 zwischen dem Emitter und der negativen Versorgungsspannung -V. Den zugehörigen Basisstrom liefert der Ausgang des zugehörigen Operationsverstärkers U1 bzw. U2. Hier zeigt sich nun ein Problem, denn der durch den Widerstand R4 bzw. R5 bestimmte Strom muss identisch mit dem vom Operationsverstärker U1 bzw. U2 gelieferten Basisstrom sein, da dieser Strom nur mit den Spannungsquellen V3, V4 verknüpft ist und kein anderen Strompfad zur Verfügung steht. Es wird also nicht der Emitterruhestrom geregelt, sondern der Basisstrom. Der resultierende Emitterruhestrom, der im wesentlichen von der schwebenden Spannungsversorgung V1 bzw. V2 gespeist wird und über die Last RL zurückfließt, ist direkt vom Stromverstärkungsfaktor des jeweiligen Ausgangstransistors Q1 bzw. Q2 abhängig und streut damit, was eigentlich unerwünscht ist. Die Stromregelung, genau genommen die Regelung des Basisstromes, erfolgt durch Abgriff des jeweiligen Emitterpotentials und Rückführung über einen relativ hochohmigen Widerstand R2 bzw. R3 auf den invertierenden Eingang des ersten bzw. zweiten Operationsverstärkers U1, U2. Damit beide Emitter, die ja auch die Anschlusspunkte für die Last RL bilden, möglichst auf gleichem Potential liegen, sind diese beiden Schaltungsknoten ebenfalls über einen relativ hochohmigen Widerstand R6 miteinander verbunden und somit wird auch die Differenz der beiden Potentiale als eine Art Offsetspannung auf die invertierenden Eingänge der Operationsverstärker U1, U2 zurückgeführt. Damit im Ansteuerungsfall der relativ kleine Ruhestrom nicht die Aussteuerung der Ausgangstransistoren Q1, Q2 behindert, vergrößert sich der jeweilige Emitterstrom durch eine Widerstands-Diodenstrecke R7, D1 bzw. R8, D2, die dem jeweiligen Emitter einen niederohmigeren Strompfad nach Masse GND zur Verfügung stellt, wenn die Diode leitend wird. Es wird noch erwähnt, das durch die in Fig. 3 dargestellte Basisstromrückführung in die Operationsverstärker U1, U2 nur stromgesteuerte Endstufen, also Bipolartransistoren, angesteuert werden können, nicht jedoch spannungsgesteuerte Bauelemente.

Fig. 4 zeigt schematisch das Schaltbild eines ersten Ausführungsbeispiels eines symmetrischen Gegentaktverstärkers nach der Erfindung. Die beiden Signalpfade sind symmetrisch aufgebaut und enthalten jeweils einen Vorverstärkerblock N1B bzw. N2B und einen Endverstärker M1 bzw. M2. Die Endverstärker M1, M2 sind jeweils an eine schwimmende Spannungsversorgung V1, V2 angeschlossen, wobei die Laststromkreise über eine Last RL, die zwischen den Fußpunkten der beiden Endverstärker M1, M2 angeschlossen ist, überkreuz geschlossen sind. Die beiden Fußpunkte der Endverstärker stellen auch gleichzeitig die Anschlusspunkte oder Anschlussklemmen RL1, RL2 für die extern anzuschließende Last RL dar und bilden den Signalausgang.

Die Spannungsversorgungseinrichtung der Vorverstärkerblöcke N1B, N2B enthält mindestens zwei in Serie geschaltete Spannungsquellen V3, V4, deren Verbindungspunkt an Masse GND liegt. Die resultierenden Versorgungsspannungen +Ub und -Ub speisen die Versorgungsanschlüsse der Vorverstärkerblöcke, die im Ausführungsbeispiel von Fig. 4 jeweils aus einem eingangsseitigen Verstärker N1, N2 mit hoher Leerlaufverstärkung bestehen. Der positive Pol der Ausgangsstufe der Verstärker N1, N2 ist mit der positiven Versorgungsspannung +Ub oder mit einer anderen positiven und ebenfalls massebezogenen Spannungsquelle gespeist. Der negative Pol der Ausgangsstufe der Verstärker N1, N2 ist über einen Potentialdifferenzerzeuger 4, 5 mit dem zugehörigen Lastanschluss RL1, RL2 verbunden. Über diesen Potentialdifferenzerzeuger 4, 5 fließt ein eingeprägter Strom. Durch die hohe Leerlaufverstärkung in Verbindung mit einem hochohmigen nichtinvertierenden und hochohmigen invertierenden Eingang, mit vernachlässigbarer Offsetspannung und vernachlässigbarem Offsetstrom und mit einem niederohmigen Ausgang haben die Verstärker N1, N2 ein Verhalten wie ein mehr oder weniger idealer Operationsverstärker.

Als Endverstärker M1, M2 sind in Fig. 4 zwei Dreipole dargestellt, deren jeweilige Eingangselektrode an den Ausgang des vorausgehenden Verstärkers N1, N2 angeschlossen ist. Der erste Endverstärker M1 ist von einer schwimmenden ersten Spannungsquelle V1 und der zweite Endverstärker M2 ist von einer schwimmenden zweiten Spannungsquelle V2 gespeist. Der erste Endverstärker M1 ist über seinen ersten Versorgungsanschluss mit einem Pol der ersten Spannungsquelle V1 und über seinen zweiten Versorgungsanschluss, der auch als Endverstärkerausgang dient, mit dem ersten Ausgang RL1 und über die Last RL mit dem anderen Pol der ersten Spannungsquelle V1 verbunden. Der zweite Endverstärker M2 ist über seinen ersten Versorgungsanschluss mit einem Pol der zweiten Spannungsquelle V2 und über seinen zweiten Versorgungsanschluss, der auch als Endverstärkerausgang dient, mit dem zweiten Ausgang RL2 und über die Last RL mit dem anderen Pol der zweiten Spannungsquelle V2 verbunden,

Die erforderliche arbeitspunktbestimmende Steuerspannung wird in den zugehörigen Potentialdifferenzerzeugern 4, 5 durch einen von einer Ruhestromeinstelleinrichtung Ix mit einer einstellbaren Stromquelle I1 vorgegebenen Strom bestimmt, der über die Potentialdifferenzerzeuger 4, 5 den gewünschten Potentialversatz erzeugt. Die mit dem negativen Versorgungsanschluss -Ub verbundene Ruhestromeinstelleinrichtung Ix enthält eine einstellbare Stromquelle I1, deren Strom mittels der beiden mit den Ausgangsanschlüssen RL1, RL2 verbundenen Widerstände R2, R3 hälftig auf die beiden Potentialdifferenzerzeuger 4, 5 aufgeteilt wird, so dass die Arbeitspunkteinstellung für die beiden Endverstärker M1, M2 symmetrisch erfolgt.

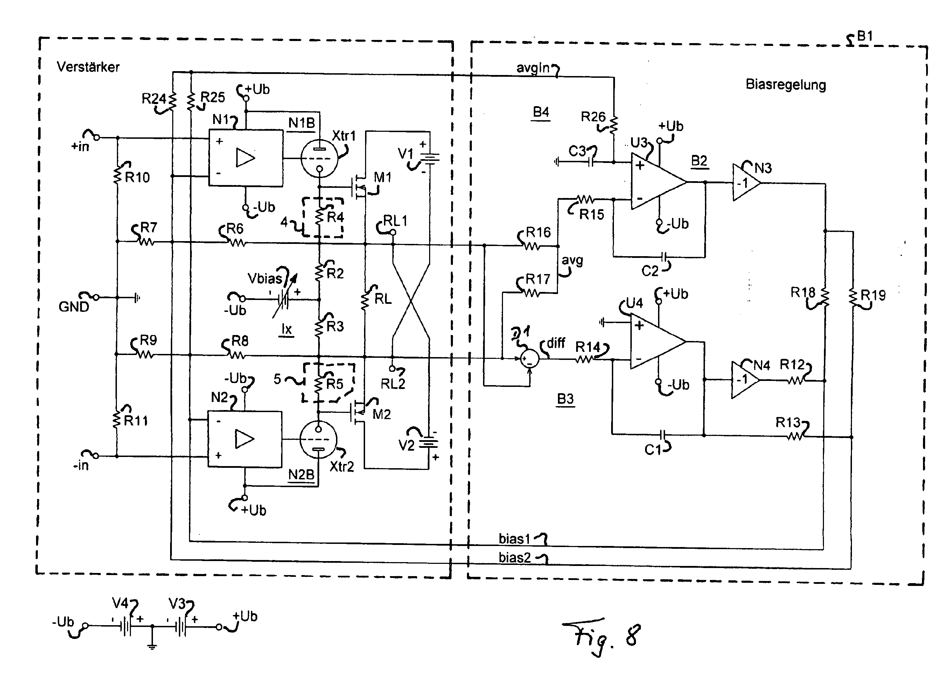

Dieser Einstellvorgang kann selbstverständlich auf verschiedene Weisen erfolgen, beispielsweise rein manuell wie im Ausführungsbeispiel von Fig. 4 über eine einstellbare Stromquelle I1, eine einstellbare Spannungsquelle Vbias (siehe Fig. 8) oder über ein Potentiometer, das die Stromquelle I1 steuert. Zweckmäßig ist auch eine temperaturbeeinflusste Steuerung, die über einen Temperaturfühler, der die Temperatur mindestens eines Leistungsbauelementes erfasst, die einstellbare Strom- oder Spannungsquelle I1 bzw. Vbias so beeinflusst, dass der Ruhestrom der Leistungsbauelemente der Endverstärker M1, M2 konstant bleibt oder einen vorgegebenen Temperaturverlauf aufweist. Noch weitergehend ist eine vollständige automatische Regelung dergestalt, dass der aktuelle Ruhestromwert der Leistungsbauelemente der Endverstärker M1, M2 gemessen und mit einem vorgegebenen Sollwert verglichen wird und auftretende Abweichungen vom Sollwert durch automatisches Nachstellen der Ruhestromeinstelleinrichtung Ix weggeregelt werden.

Selbstverständlich sind auch Kombinationen dieser beschriebenen Regelungsmaßnahmen unter Schutz gestellt.

Die beiden Verstärker N1 und N2 haben einen invertierenden und einen nichtinvertierenden Eingang und entsprechen wegen ihrer hohen Leerlaufverstärkung jeweils einem Operationsverstärker. Als Ausgang des resultierenden Operationsverstärkers sieht man dabei am zweckmäßigsten den Lastanschluss RL1 bzw. RL2 an, der durch ein Rückkopplungsnetzwerk auf das Massepotential GND geregelt wird. Das Rückkopplungsnetzwerk wird durch die seriengeschaltete Widerstände R6 und R7 bzw. R8 und R9 gebildet, die zwischen dem Lastanschluss RL1 und Masse GND bzw. dem Lastanschluss RL2 und Masse GND liegen. Der gemeinsame Verbindungspunkt der Widerstände R6, R7 bzw. R8, R9 ist mit dem invertierenden Eingang des Verstärkers N1 bzw. N2 verbunden. Der nichtinvertierende Eingang des ersten Verstärkers N1 ist mit dem positiven Signaleingang +in und der nichtinvertierende Eingang des zweiten Verstärkers N2 ist mit dem negativen Signaleingang -in des Gegentaktverstärkers verbunden. Durch das Rückkopplungsnetzwerk R6, R7 bzw. R8, R9 wird der Ausgang des Verstärkers N1 bzw. N2 so geregelt, dass über den Potentialdifferenzerzeuger 4, 5 und den Spannungsteiler R6, R7 bzw. R8, R9 das Potential am nichtinvertierenden Eingang des Verstärkers N1 bzw. N2 identisch zum Potential am positiven bzw. negativen Signaleingang +in bzw. -in ist. Diese Regelung über das Rückkopplungsnetzwerk ist unabhängig von der Größe der Ruhestromeinstellung für die Leistungsbauelemente der Endverstärker M1, M2, die durch die einstellbare Stromquelle I1 vorgegeben ist. Der resultierende Pegelversatz am Potentialdifferenzerzeuger 4 bzw. 5 wird durch den Verstärker N1 bzw. N2 ausgeregelt.

Die Widerstände R10 und R11 vom positiven bzw. negativen Signaleingang nach Masse GND haben für die Rückkopplung keine Bedeutung. Sie dienen lediglich der Festlegung des GND-Potentiales für die jeweiligen nichtinvertierenden Eingänge von N1 und N2 sowie der Leitungsanpassung, da die Signaleingänge an den nichtinvertierenden Eingängen der Verstärker N1 und N2 in der Regel hochohmig sind. Später wird ein Ausführungsbeispiel gezeigt, bei dem die Signaleingänge an die invertierenden Eingänge der Verstärker N1 und N2 angeschlossen sind. Durch das an diese Eingänge angeschlossene Rückkopplungsnetzwerk sind diese Eingänge dann wesentlich niederohmiger, so das eine Leitungsanpassung gegebenenfalls entfallen kann.

Um einen erfindungsgemäß vollsymmetrischen Verstärker für ein symmetrisches Eingangssignal zu realisieren, müssen die entsprechenden Widerstände in den beiden Signalzweigen selbstverständlich gleich sein. Es gilt R6 = R8 und R7 = R9. Das Verhältnis der Widerstände R6/R7 bzw. R8/R9 bestimmt die Gesamtverstärkung des Gegentaktverstärkers.

Die obere Verstärkerhälfte, im wesentlichen aus den Baugruppen N1B und M1 bestehend, verstärkt die eine Halbwelle des symmetrischen Eingangssignals und die untere Verstärkerhälfte, bestehend aus den Baugruppen N2B und M2, verstärkt die andere Halbwelle.

Die Endverstärker M1, M2 können auf vielfältige Weise praktisch realisiert werden: als einzelne Leistungsbauelemente wie z.B. Leistungs-MOSFETS, IGBTs oder bipolare Leistungstransistoren, aber auch vorteilhaft aus Kombinationen gleichartiger oder verschiedener Verstärkerbauelemente mit oder ohne lokale Gegenkopplung.

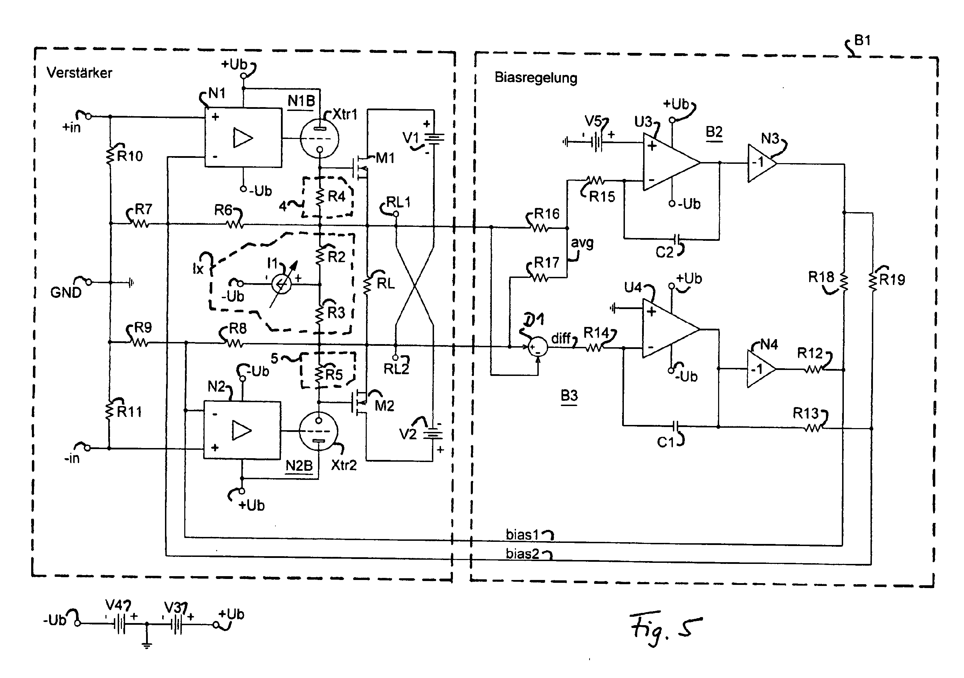

Im Schaltbild von Fig. 5 ist die Ausgangsstufe der Vorverstärkerblöcke N1B und N2B beispielhaft als Triode Xtr1 bzw. Xtr2 ausgeführt. Im Ausführungsbeispiel von Fig. 5 bestehen die Vorverstärkerblöcke N1B und N2B damit jeweils aus der Kombination eines eingangsseitigen Verstärkers N1, N2 mit hoher Leerlaufverstärkung und einer an den Verstärker N1, N2 angeschlossenen Röhre Xtr1, Xtr2, deren Steuergitter mit dem zugehörigen Verstärkerausgang verbunden ist. Die Anode der Röhre Xtr1, Xtr2 ist mit der positiven Versorgungsspannung +Ub oder mit einer anderen positiven und ebenfalls massebezogenen Spannungsquelle verbunden. Die Kathode der Röhre Xtr1, Xtr2 ist über einen Potentialdifferenzerzeuger 4, 5, der im einfachsten Fall einen Widerstand R4, R5 enthält und über den ein eingeprägter Strom fließt, mit dem zugehörigen Lastanschluss RL1, RL2 verbunden.

Für die im Ausführungsbeispiel Fig. 5 als Trioden dargestellten Röhren Xtr1, Xtr2 können selbstverständlich auch Tetroden, Pentoden, Hexoden und Heptoden mit dem Stand der Technik entsprechender Beschaltung der zusätzlichen Gitter eingesetzt werden.

Als Endverstärker M1, M2 sind in Fig. 5 zwei n-Kanal-MOSFETs dargestellt, deren jeweilige Gateelektrode an die Kathode der vorausgehenden Röhre Xtr1, Xtr2 angeschlossen ist. Die jeweilige Sourceelektrode ist mit dem zugehörigen Lastanschluss RL1, RL2 und die jeweilige Drainelektrode mit dem positiven Potential der schwimmenden Spannungsquelle V1, V2 verbunden. Die arbeitspunktbestimmende Gate-Source-Steuerspannung wird in den zugehörigen Potentialdifferenzerzeugern 4, 5 durch einen von einer Ruhestromeinstelleinrichtung Ix mit einer einstellbaren Stromquelle I1 vorgegebenen Strom bestimmt, der über die Widerstände R4, R5 den gewünschten Potentialversatz erzeugt. Die mit dem negativen Versorgungsanschluss -Ub verbundene Ruhestromeinstelleinrichtung Ix enthält eine einstellbare Stromquelle I1, deren Strom mittels der beiden mit den Ausgangsanschlüssen RL1, RL2 verbundenen Widerstände R2, R3 hälftig auf die beiden Widerstände R4, R5 aufgeteilt wird, so dass die Arbeitspunkteinstellung für die beiden MOSFETs M1, M2 symmetrisch erfolgt.

Zur Vereinfachung der Funktionsbeschreibung wurde entsprechend dem Ausführungsbeispiel von Fig. 4 zunächst davon ausgegangen, dass die Verstärker N1 und N2 ein Verhalten wie ein idealer Operationsverstärker haben. Die Ausführungsbeispiele ab Fig. 5 gehen davon aus, dass die aktiven Bauelemente in den beiden Signalzweigen von den idealen Eigenschaften abweichen und auch bezüglich der Symmetriebedingung mehr oder weniger zueinander unterschiedlich sind. Mittels ergänzender Regelkreise nach Weiterbildungen der Erfindung lassen sich aber derartige Unzulänglichkeiten für die Gesamtfunktion des Gegentaktverstärkers beseitigen.

Im Schaltbild von Fig. 5 ist schematisch eine derartige Regelungsanordnung als "Biasregelung" B1 dargestellt, die den Gegentaktverstärker von Fig. 4 ergänzt. Da gleiche Schaltungs- und Funktionseinheiten in allen Figuren der Zeichnung mit gleichen Bezugzeichen versehen sind, erübrigen sich wiederholende Funktionsbeschreibungen. Der Schaltungsblock B1 enthält zwei Regelkreise B2, B3, deren Eingänge mit den Verstärkerausgängen RL1, RL2 und deren Ausgänge mit den Rückführungsnetzwerken der beiden Vorverstärkerblöcke N1B bzw. N2B verkoppelt sind.

Der Eingang des ersten Regelkreises B2 wird durch zwei in Serie geschaltete gleichgroße Widerstände R16, R17 gebildet, die an die Ausgänge RL1, RL2 angeschlossen sind und deren gemeinsamer Verbindungspunkt avg über einen Widerstand R15 auf den invertierenden Eingang eines Operationsverstärkers U3 geschaltet ist. Am nichtinvertierenden Eingang von U3 ist eine Gleichspannung V5 angelegt. Der Ausgang des Verstärkers U3 ist mittels eines Kondensators C2 auf den nichtinvertierenden Eingang zurückgeführt. Die Spannungsversorgung des Verstärkers U3 erfolgt zweckmäßigerweise über die bereits vorhandenen Versorgungspotentiale +Ub und -Ub oder über eine andere Versorgungsspannung. Ein am Ausgang von U3 angeschlossener Inverter N3 invertiert das Ausgangssignal und führt es über einen Widerstand R18 auf den gemeinsamen Verbindungspunkt der Widerstände R8, R9 und damit invertierenden Eingang des Verstärkers N2 zurück. Für die weitere Betrachtung wird dieser Schaltungsknoten, der eine wichtige Schnittstelle für die Regelung und in Fig. 5 auch als Leitung dargestellt ist, mit "bias 1" bezeichnet. Eine zweite Rückführung des Ausgangssignals von Verstärker U3 erfolgt über einen Widerstand R19 auf den gemeinsamen Verbindungspunkt der Widerstände R6, R7 und damit invertierenden Eingang des Verstärkers N1. Für die weitere Betrachtung wird dieser Schaltungsknoten, der ebenfalls eine wichtige Schnittstelle für die Regelung und in Fig. 5 auch als Leitung dargestellt ist, mit "bias 2" bezeichnet.

Der Eingang des zweiten Regelkreises B3 wird durch einen Subtrahierer D1 gebildet, dessen Minuendeingang + mit dem Lastanschluss RL2 und dessen Subtrahendeingang - mit dem Lastanschluss RL1 verbunden ist. Der Ausgang des Subtrahierers D1 bestimmt das Potential des Knotens diff und ist über einen Widerstand R14 mit dem invertierenden Eingang eines Verstärkers U4 verbunden, der über einen Kondensator C1 mit seinem Verstärkerausgang verbunden ist. Dieser Ausgang ist ferner über eine Serienschaltung aus einem Inverter N4 und einem Widerstand R12 mit dem Schaltungsknoten bias 1 und über einen Widerstand R13 mit dem anderen Schaltungsknoten bias 2 verbunden. Am nichtinvertierenden Eingang des Verstärkers U4 ist das Massepotential GND angeschlossen.

Die erfindungsgemäße Funktion des Regelungsblockes Biasregelung B1 besteht darin, dass mittels der ersten Regelungsschleife B2 der Mittelwert avg der Potentiale an den Ausgängen RL1, RL2 erfasst und mit einer vorgegebenen Sollspannung V5 verglichen wird. Über den vom Verstärker U3 gebildeten Integrator wird die Abweichung des Potentials avg vom Sollwert V5 verstärkt. Mittels des Invertierers N3 und der Widerstände R18 und R19 wirkt diese verstärkte Abweichung vom Sollwert V5 in gleicher Weise so auf die beiden direkt gekoppelten Regelschnittstellen bias 1 und bias 2 ein, dass der Mittelwert der Potentiale an den Ausgangsanschlüssen RL1, RL2 auf den vorgegebenen Sollwert V5 eingeregelt wird. Damit wird der Betrag des Absolutpotentials der Ausgänge RL1, RL2 definiert eingestellt.

Mittels der zweiten Regelungsschleife B3 wird der zeitliche Mittelwert der vorzeichenbehafteten Differenz diff der Potentiale an den Ausgängen RL1, RL2 erfasst, dieser Wert mit einer vorgegebenen Sollspannung verglichen und Abweichungen mittels des aus dem Verstärker U4 gebildeten Integrators über die beiden Regelschnittstellen bias 1 und bias 2 ausgeregelt. Da die Differenzspannung in der Regel vernachlässigbar klein sein soll, also im Bereich von 0 V, wird dem Referenzeingang (=nichtinvertierenden Eingang) des Verstärkers U4 als Referenzspannung das Massepotential GND zugeführt. Da mögliche Abweichungen sich in der Regelrichtung unterschiedlich auf die beiden Regelschnittstellen bias 1, bias 2 auswirken müssen, ist in die Rückführung auf die Schnittstelle bias 1 der Inverter N4 eingefügt.

Die Zeitkonstante $\tau2 = R14 * C1$ der zweiten Regelschleife B3 wird so gewählt, dass keine Beeinflussung der zu verstärkenden Wechselspannungssignale (=AC-Signale) im vorgesehenen Nutzfrequenzbereich des Gegentaktverstärkers erfolgt. Für den Einsatz als Audioverstärker ist beispielsweise $\tau2$ größer oder gleich 1s sinnvoll.

Die Zeitkonstante $\tau1 = R15 * C2$ der ersten Regelschleife B2 wird so eingestellt, dass ebenfalls ein Wert größer oder gleich 1s erreicht wird, um bei eventuellen Abweichungen vom idealen symmetrischen Verhalten eine Beeinflussung der zu verstärkenden AC-Signale im vorgesehenen Nutzfrequenzbereich zu vermeiden.

Werden die Verstärker N1 bzw. N2 in den Vorverstärkerblöcken so realisiert, dass im Ruhezustand ein erheblicher, auch driftbelasteter, Potentialunterschied zwischen dem nichtinvertierenden und dem invertierendem Eingang dieser Verstärker N1, N2 auftritt, so kann durch eine geeignete Ausführung der Biasregelung dieser störende Einfluss auf die Arbeitspunktstabilität minimiert werden.

Ein derartiger Fall ergibt sich beispielsweise, wenn die Verstärker N1, N2 nicht in Halbleitertechnik sondern in Röhrentechnik ausgeführt sind. Dabei könnte zum Beispiel die erste Stufe eines Röhrenverstärkers als Kathodenbasisstufe realisiert sein. In diesem Fall entspricht zum Beispiel das Gitter dem nichtinvertierenden Eingang des Verstärkers N1 bzw. N2 und die Kathode dem invertierenden Eingang von N1 bzw. N2. Durch den Kathodenstrom ergibt sich eine Potentialanhebung über den Widerstand R7 bzw. R9. Würde wie in dem Beispiel von Fig. 5 die Sollspannung V5 = 0V betragen, so würde durch das dann im Ruhezustand auf 0V eingeregelte Absolutpotential von RL1 bzw. RL2 eine Potentialdifferenz über die Rückkopplungswiderstände R6 und R8 entstehen. Das führt wiederum zu einer anteiligen Biasstromaufteilung in Abhängigkeit von den Widerständen R2, R4, R6 bzw. R3, R5, R8 mit:

$$I(R2) = I(R4) + I(R6) \quad bzw. \quad I(R3) = I(R5) + I(R8).$$

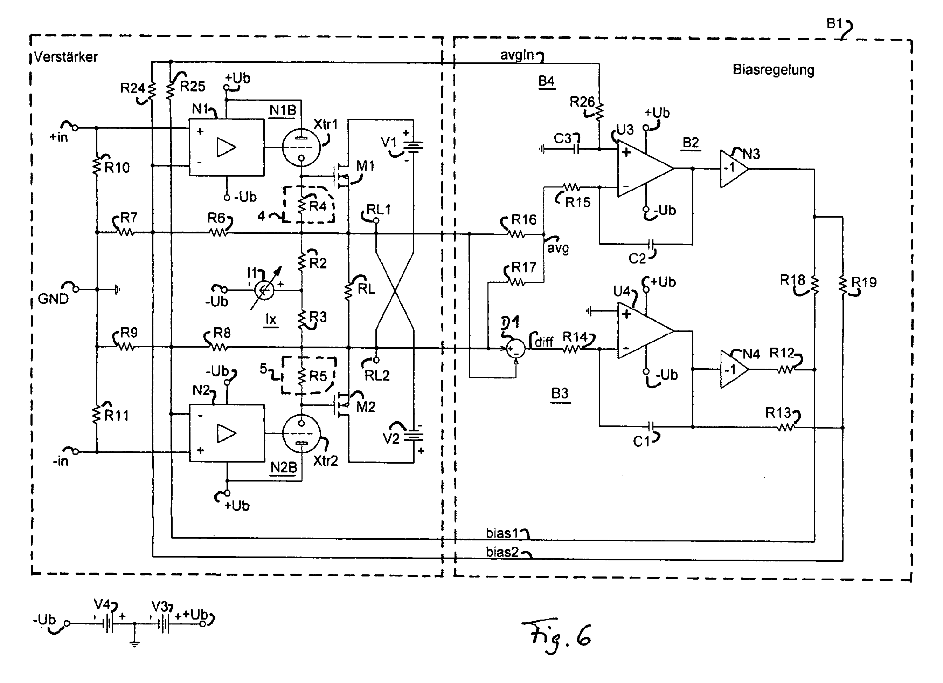

Die Arbeitspunkte von Röhren sind thermischen und alterungsbedingten Schwankungen unterworfen. Damit ändert sich über die Temperatur und die Alterung der Eingangsröhren, die im wesentlichen die Spannungsverstärkung in den Verstärkern N1 bzw. N2 bewirken, der Stromanteil I(R6) bzw. I(R8), und damit nach der ersten Beziehung das durch I(R4) bestimmte Potential der Gate-Source-Strecke des Endverstärkers M1. Entsprechend negativ wirkt sich das durch den Strom I(R5) bestimmte Potential auf die Gate-Source-Strecke des Endverstärkers M2 aus. Um diesen störenden Einfluss auszuschließen oder zumindest zu minimieren wird die Sollspannung V5 nicht fest eingestellt, sondern wie im Ausführungsbeispiel von Fig. 6 werden die Regelschnittstellen bias 1 und bias 2 über die in Reihe geschalteten gleichgroßen Widerstände R24 und R25 miteinander verknüpft, so dass an dem gemeinsamen Widerstandsabgriff eine neue Knotenspannung avgln für einen dritten Regelkreis B4 zur Verfügung steht. Diese Knotenspannung avgln wird über einen Widerstand R26 auf den nichtinvertierenden Eingang des Regelverstärkers U3 geführt, der anders als in Fig. 5 nicht mit einer Referenzspannung V5 gespeist ist, sondern der seine Referenzspannung an diesem Anschluss selbst erzeugt, indem ein Kondensator C3 dort angeschlossen ist. Der Mittelwert der Potentiale an den Regelschnittstellen bias 1 und bias 2 wird somit über das RC-Glied R26 und C3 tiefpassgefiltert und dient dann als Sollspannung am nichtinvertierenden Eingang des Regelverstärkers U3. Die Eckfrequenz des RC-Gliedes R26, C3 wird bevorzugt mindestens eine Dekade tiefer als die unterste zu übertragende Nutzsignalfrequenz gewählt. Durch diese in Fig. 6 dargestellte Schaltungsvariante wird der grundsätzliche oder driftbedingte Potentialunterschied zwischen den Eingängen der Verstärker N1 bzw. N2, auf die über das Gegenkopplungsnetzwerk ein Teil der Ausgangsspannung zurückgeführt wird, und den Ausgangsknoten RL1 bzw. RL2 ideal zu Null geregelt oder zumindest so klein, dass damit der Fehleranteil der Ruhestromregelung keinen Einfluss mehr hat.

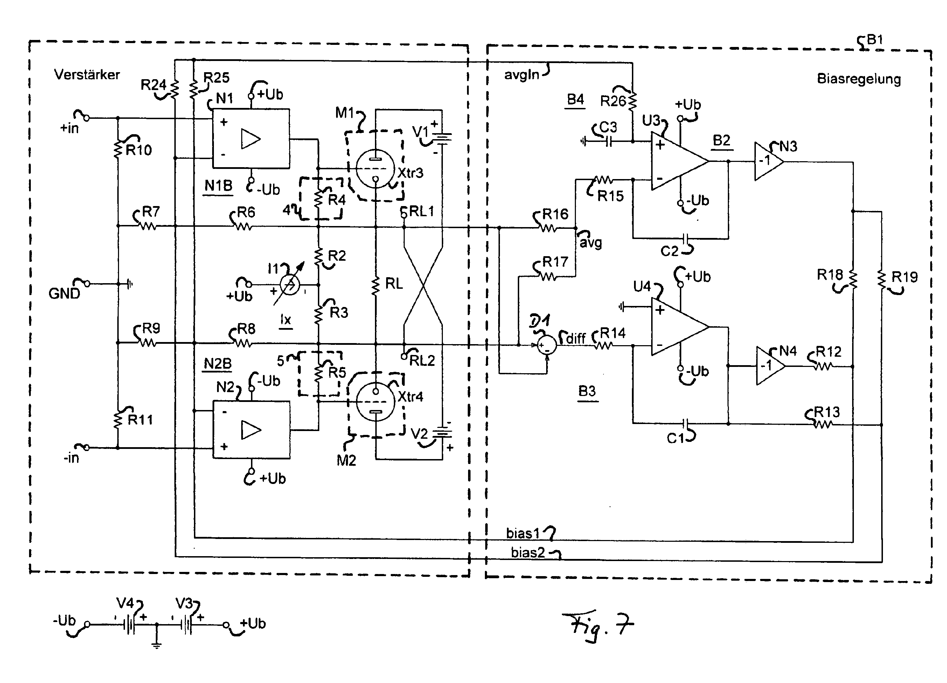

Wie bereits erwähnt, besteht ein wesentlicher Vorteil des durch die Erfindung vorgeschlagenen Gegentakt-Verstärkerprinzips in der weitgehend freien Wahl der aktiven Bauelemente. Zum Beispiel können als Leistungsbauelemente alle bekannten Bauelementetypen verwendet werden. In den Ausführungsbeispielen von Fig. 5 und Fig. 6 wurden als Endverstärker M1, M2 exemplarisch n-Kanal-MOSFETs gezeigt. Ohne Strukturänderung können in diesen Schaltungen auch andere Leistungsbauelemente verwendet werden, auch solche die nicht selbstleitend sind wie z.B. IGBTs und Bipolartransistoren. Werden selbstleitende Bauelemente, die eine negative Vorspannung erfordern, beispielsweise Röhren und einige JFETs, eingesetzt, kann durch eine geringfügige Änderung der Schaltungsstruktur die erfindungsgemäße Funktionsweise in gleicher Weise gesichert werden. Ein hierzu gehöriges Prinzipschaltbild eines entsprechenden Ausführungsbeispieles zeigt Fig. 7.

In Fig. 7 ist ein Ausführungsbeispiel des Gegentaktverstärkers dargestellt, der als Endverstärker M1, M2 jeweils Röhren Xtr3, Xtr4 aufweist, die direkt die Last RL treiben. Die Vorverstärkerblöcke N1B, N2B enthalten im Gegensatz zu den vorausgehenden Ausführungsbeispielen nach Fig. 5 und Fig. 6 keine Kombinationsverstärker, sondern bestehen allein aus den Verstärkern N1, N2. Diese sind so realisiert, dass sie im Ruhezustand eine negative Ausgangsgleichspannung von einigen Volt bis einigen zehn Volt je nach den angeschlossenen Röhren Xtr3, Xtr4 aufweisen. Die einstellbare Stromquelle I1 ist hierzu an ein positives Potential +Ub geschaltet, so dass deren hälftiger Strom über die Widerstände R2, R3, die Pegelumsetzer 4, 5 und die interne Ausgangsstufe von N1, N2 zur negativen Versorgungsspannung -Ub fließt. Dieser Stromfluss verursacht an den Widerständen R4, R5 die erforderliche negative Gittervorspannung für die Röhren Xtr3 bzw. Xtr4. Es wird damit wieder mit nur einer Stellgröße der Ruhestrom beider Röhren Xtr3, Xtr4 in den schwimmenden ohne festen Massebezug betriebenen Endverstärkern M1, M2 definiert und synchron sowie symmetrisch eingestellt. Wie schon weiter oben beschrieben, kann der Einstellvorgang von 11 und damit der Ruhestrom der Röhren Xtr3, Xtr4 auf vielfältige Weise manuell, temperaturgesteuert oder mittels eines automatischen Ruhestromregelkreises ausgeführt werden. In der beispielhaften Darstellung von Fig. 7 wurden Trioden verwendet. Für Xtr3, Xtr4 können aber alle bekannten Röhrentypen wie z.B. auch Tetroden und Pentoden eingesetzt werden.

Muss die Last RL in einem speziellen Bedarfsfall mittels eines Übertragers an die mit Röhren ausgestattete Leistungsendstufe M1, M2 angekoppelt werden, kann dies mit der gleichen Struktur wie in Fig. 7 erfolgen, nur dass dann statt der direkten Lastankopplung ein Übertrager in bekannter Art und Weise den Innenwiderstand der Röhrenendstufe an die niederohmige Last heruntertransformiert. Der Übertrager kann dabei kostensparend als Spartransformator ausgeführt werden, da durch die erfindungsgemäße Ruhestromeinstellung keine Gleichstromvormagnetisierung auftritt. Zweckmäßigerweise wird der Spartransformator symmetrisch gewickelt, beispielsweise in einem Zweikammeraufbau, so dass sich gleiche Wicklungswiderstände für beide Wicklungshälften ergeben. Dank der fehlenden Gleichstromvormagnetisierung ist auch eine Realisierung als Ringkerntransformator möglich. Die Wicklung wird in diesem Fall auf ganzzahlige gleiche Teile aufgeteilt, die dann paarweise bifilar gewickelt werden. Eine Abweichung vom Symmetrieprinzip, beispielsweise durch einfaches Aufeinanderwickeln der jeweiligen Wicklungen, ermöglicht immer noch eine stabile Arbeitsweise des erfindungsgemäßen Gegentaktverstärkers, schöpft dessen Möglichkeiten aber nicht voll aus.

Ein weiteres Ausführungsbeispiel des erfindungsgemäßen Gegentaktverstärkers zeigt Fig. 8. Diese Schaltung ist nahezu identisch zur Schaltung von Fig. 6, nur dass die Stellgröße für die Ruhestromeinstellung nicht wie in Fig. 6 durch die einstellbare Stromquelle I1 erfolgt, sondern durch eine einstellbare Spannungsquelle Vbias, die letztendlich über die Widerstände R2, R3 aber ebenfalls einen Strom erzeugt, der mittels dieser Widerstände R2, R3 hälftig aufgeteilt wird und über die Widerstände R4, R5 den gewünschten arbeitspunktbestimmenden Potentialversatz für die jeweilige Gate-Source-Strecke der beiden n-Kanal-MOSFETs im Endverstärker M1, M2 erzeugt.

Erfindungsgemäß ist der Absolutwert der Potentiale an den Lastanschlüssen RL1, RL2 definiert und auf einen annähernd gleichen Wert eingeregelt. Da die Widerstände R2 und R3 einander gleich sind, sind auch die durch sie hindurchfließenden Ströme I(R2) und I(R3) einander gleich. Diese Ströme fließen annähernd vollständig über die Widerstände R4 bzw. R5 und von der Kathode zur Anode der Triode Xtr1 bzw. Xtr2 zur positiven Betriebsspannung +Ub. Durch den resultierenden Potentialversatz an den Widerständen R4 bzw. R5 wird ein definierter positiver Potentialunterschied zwischen der Gate-Source-Strecke der MOSFETs M1 bzw. M2 erzeugt und damit fließt folgerichtig ein definierter Ruhestrom durch diese Endstufentransistoren. Der Einstellvorgang der Spannungsquelle Vbias kann wieder auf vielfältige Weise erfolgen, manuell, temperaturgesteuert oder mittels eines automatischen Ruhestromregelkreises.

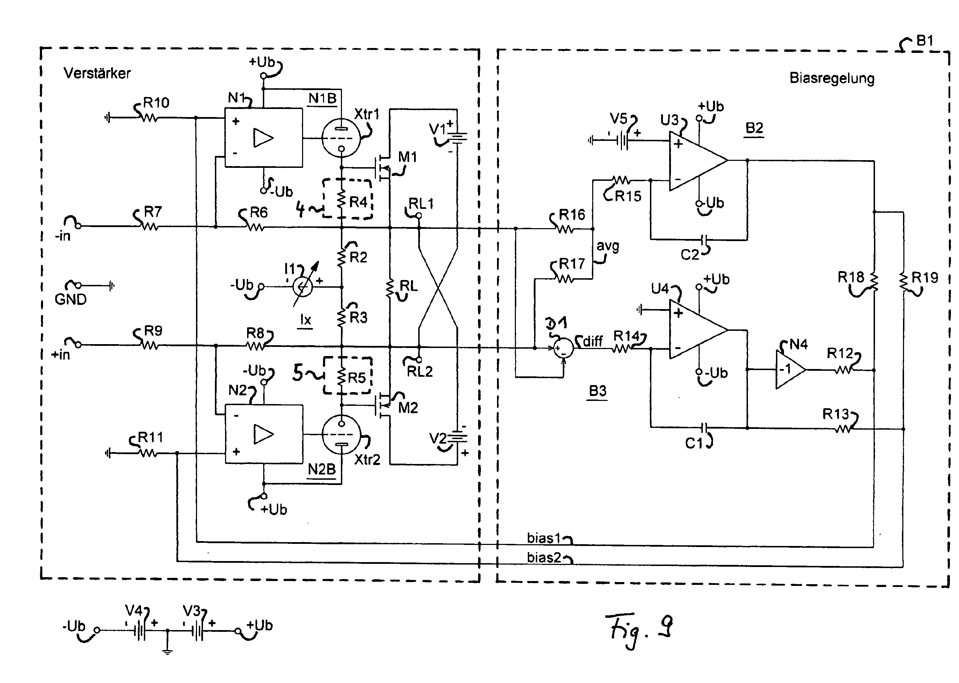

Entsprechend dem Ausführungsbeispiel von Fig. 9 ist ein erfindungsgemäßer Gegentaktverstärker auch dadurch realisierbar, dass die eingangsseitigen Verstärker N1, N2 in den Vorverstärkerblöcken N1B, N2B jeweils mit ihrem invertierenden Verstärkereingang an die Signaleingänge -in bzw. +in des Gegentaktverstärkers angeschlossen sind. Im Eingangsbereich der Verstärker N1, N2 sind dabei nur geringfügige Schaltungsänderungen vorzunehmen. Die Widerstände R7 bzw. R9 der Rückkopplungsnetzwerke sind nun nicht an das Massepotential angeschlossen wie beispielsweise in der vergleichbaren Fig. 5, sondern an den negativen bzw. positiven Signaleingang -in bzw. +in des Gegentaktverstärkers. Die Widerstände R10 bzw. R11 an den nichtinvertierenden Eingängen der Verstärker N1 bzw. N2 sind an den vom Verstärker abgewandten Enden mit dem Massepotential GND verbunden. Ferner sind die rückgeführten Leitungen der Regelschnittstellen bias 1 bzw. bias 2 nicht mehr wie in Fig.5 auf den invertierenden Eingang der Verstärker N1 bzw. N2 zurückgeführt, sondern auf deren nichtinvertierende Eingänge. Die von den Regelkreisen B2 und B3 rückgeführten Regelströme erzeugen über die Widerstände R10 bzw. R11 die erforderlichen Regelspannungen für die Verstärker N1, N2.

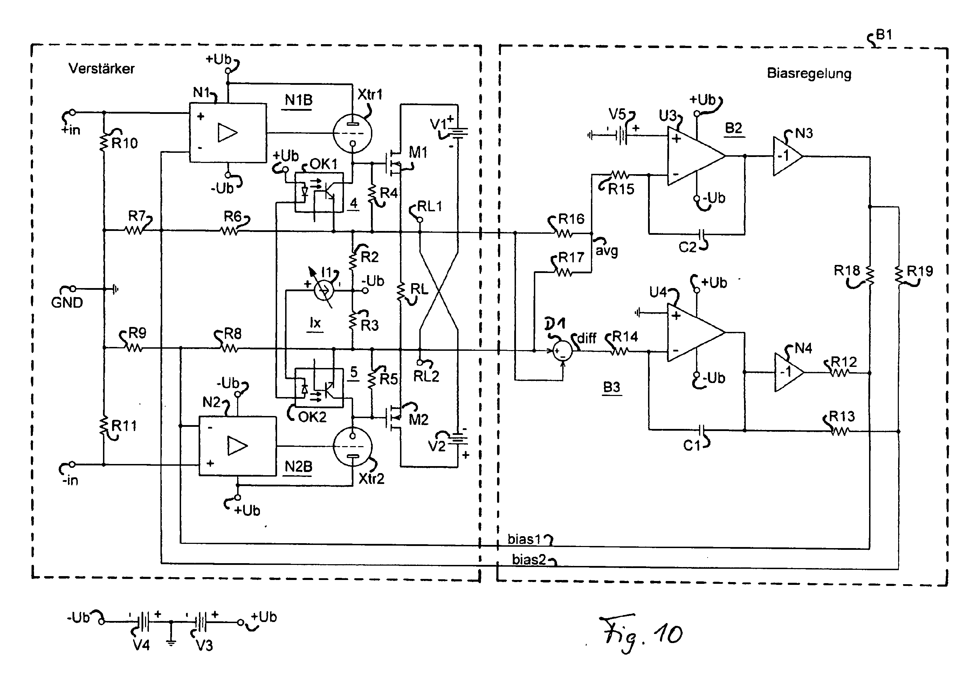

Das Ausführungsbeispiel nach Fig. 10 zeigt eine weitere Variante der Ruhestromeinstellung. Die Grundschaltung dieses Gegentaktverstärkers ist etwa vergleichbar mit der Schaltung von Fig. 5. Die Potentialdifferenzerzeuger 4 und 5 enthalten neben den Widerständen R4 und R5 jeweils ein optoelektronisches Bauelement OK1 bzw. OK2 oder sind mit derartigen Bauelementen gekoppelt. Über eine gemeinsame Stromquelle I1 wird die Lichtemission jeweils eines LED-Elements gesteuert, von dessen Intensität der Durchgangswiderstand eines lichtempfindlichen Photo-Transistors abhängig ist. Dieser Photo-Transistor liegt parallel zu dem bereits von Fig. 5 bekannten Widerstand R4 bzw. R5, der über den ebenfalls bekannten Widerstand R2 bzw. R3 gespeist ist, dessen Fußpunkt aber im Gegensatz zu Fig. 5 auf dem negativen Festpotential -Ub liegt. Die Steuerung des Potentialversatzes im Widerstand R4 bzw. R5 und damit des Ruhestromes im Endverstärker M1 bzw. M2 (hier jeweils ein n-Kanal-MOSFET) folgt nun durch die Parallelschaltung der gesteuerten Photo-Transistorstrecke, über die ein mehr oder weniger großer Anteil des vom Widerstand R2 bzw. R3 eingeprägten Stromes fließt.

Bei dem Ausführungsbeispiel von Fig. 10 werden die Potentialdifferenzerzeuger 4 bzw. 5 somit durch eine Baugruppe gebildet, die die Widerstände R4 bzw. R5 jeweils mit einer Optokopplerstrecke OK1 bzw. OK2 in sich kombiniert. Eine synchrone Einstellung des Ruhestromes beider Zweige des schwimmend spannungsversorgten Endverstärkers erfolgt durch die Beaufschlagung beider Optokoppler mit dem gleichen Steuer- oder Regelstrom. Die Stromgleichheit ist im Ausführungsbeispiel nach Fig. 10 dadurch erzwungen, dass der Strom der einstellbaren Stromquelle I1 vom negativen Versorgungsanschluss -Ub durch beide Optokoppler OK1, OK2 bis zum positiven Versorgungsanschluss +Ub hindurchgeschleift ist.

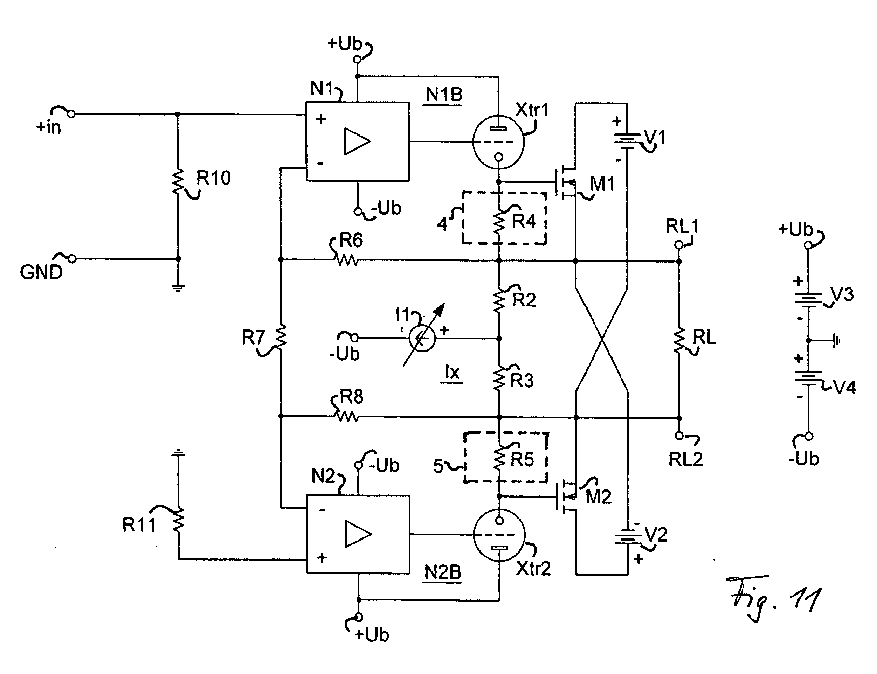

Das Ausführungsbeispiel nach Fig. 11 zeigt schließlich eine vorteilhafte Anordnung des Gegentaktverstärkers nach der Erfindung, wenn statt symmetrischer Eingangssignale grundsätzlich nur unsymmetrische Eingangssignale verarbeitet werden sollen. Zum Vergleich eignet sich die Schaltung nach Fig. 5. Damit beide Signalzweige gleichzeitig, also bei jeder Halbwelle, arbeiten können, wird der Verstärker N1 am nichtinvertierenden Eingang und der Verstärker N2 am invertierenden Eingang angesteuert. Hierzu ist der nichtinvertierende Eingang des Verstärkers N1 mit dem Signaleingang +in und über den Widerstand R10 mit dem Massepotential GND verbunden. Der invertierende Eingang des Verstärkers N1 liegt wie in Fig. 4 am Spannungsabgriff des Spannungsteilers R6, R7, wobei jedoch das abgewandte Ende des Widerstandes R7 nicht wie in Fig. 4 auf Masse liegt, sondern mit dem invertierenden Eingang des Verstärkers N2 im zweiten Signalzweig verbunden ist. Am invertierenden Eingang des Verstärkers N2 fehlt der aus Fig. 4 bekannte Widerstand R9, der zusammen mit dem Widerstand R8 den dortigen Spannungsteiler für die Rückführung vom Ausgang RL2 bildet. In Fig. 11 übernimmt diese Funktion der bereits genannte Widerstand R7, indem er beide invertierenden Eingänge der beiden Verstärker N1 und N2 miteinander koppelt. Der nichtinvertierende Eingang des Verstärkers N2 ist im Gegensatz zu Fig. 4 schließlich über den Widerstand R11 mit der Masse GND verbunden. Damit in beiden Signalzweigen die Verstärkung einander gleich ist, müssen die Widerstände folgender Beziehung folgen:

$$1 + (R6 / R7) = R8 / R7$$

Diese Bestimmungsgleichung ergibt sich aus der Tatsache, dass der obere Zweig insgesamt als nichtinvertierender Verstärker und der untere Zweig als invertierender Verstärker arbeitet. Die oben angegebenen Widerstände sind daher nicht mehr streng gleichartig, insbesondere bei relativ kleinen Verstärkungen. Bei größeren Verstärkungen ist der Unterschied im reinen Widerstandsverhältnis R6 / R7 bzw. R8 / R7 gering.

**Patentansprüche**

1.   Verstärker in symmetrischer Gegentaktausführung mit einer ersten und dazu gleichen zweiten Verstärkungseinrichtung, wobei die erste Verstärkungseinrichtung (N1B, M1) in einem ersten Signalpfad zwischen einem ersten Eingang (+in) und einem ersten Ausgang (RL1) und eine zweite Verstärkungseinrichtung (N2B, M2) in einem zweiten Signalpfad zwischen einem zweiten Eingang (-in) und einem zweiten Ausgang (RL2) angeschlossen sind, weiterhin sind ein zu verstärkendes Signal an den ersten und/oder zweiten Eingang (+in, -in) und eine extern anzuschließende Last (RL) an den ersten und zweiten Ausgang (RL1, RL2) anschließbar,

- der erste Eingang (+in) ist mit dem Signaleingang eines von einer Spannungsversorgungseinrichtung (V3, V4) gespeisten ersten Vorverstärkerblocks (N1B) und dessen Ausgang mit dem Signaleingang eines ersten Endverstärkers (M1) gekoppelt, und der zweite Eingang (-in) ist mit dem Signaleingang eines von der Spannungsversorgungseinrichtung (V3, V4) gespeisten zweiten Vorverstärkerblocks (N2B) und dessen Ausgang mit dem Signaleingang eines zweiten Endverstärkers (M2) gekoppelt,
- der erste Endverstärker (M1) ist von einer schwimmenden ersten Spannungsquelle (V1) und der zweite Endverstärker (M2) von einer schwimmenden zweiten Spannungsquelle (V2) gespeist,
- der erste Endverstärker (M1) ist über seinen ersten Versorgungsanschluss mit einem Pol der ersten Spannungsquelle (V1) und über seinen zweiten Versorgungsanschluss, der auch als Endverstärkerausgang dient, mit dem ersten Ausgang (RL1) und über die Last (RL) mit dem anderen Pol der ersten Spannungsquelle (V1) verbunden, und
- der zweite Endverstärker (M2) ist über seinen ersten Versorgungsanschluss mit einem Pol der zweiten Spannungsquelle (V2) und über seinen zweiten Versorgungsanschluss, der auch als Endverstärkerausgang dient, mit dem zweiten Ausgang (RL2) und über die Last (RL) mit dem anderen Pol der zweiten Spannungsquelle (V2) verbunden,

**dadurch gekennzeichnet, dass**

- ein erster Potentialdifferenzerzeuger (4) zwischen dem Ausgang des ersten Vorverstärkerblocks (N1B) und dem ersten Ausgang (RL1) in Abhängigkeit von einer Ruhestromeinstelleinrichtung (Ix) eine erste Differenzspannung zwischen dem Ausgang des ersten Vorverstärkerblocks (N1B) und dem ersten Ausgang (RL1) erzeugt, die den Arbeitspunkt und den Ruhestrom des ersten Endverstärkers (M1) bestimmt und
- ein zweiter Potentialdifferenzerzeuger (5) zwischen dem Ausgang des zweiten Vorverstärkerblocks (N2B) und dem zweiten Ausgang (RL2) in Abhängigkeit von der Ruhestromeinstelleinrichtung (Ix) eine zweite Differenzspannung zwischen dem Ausgang des zweiten Vorverstärkerblocks (N2B) und dem zweiten Ausgang (RL2) erzeugt, die den Arbeitspunkt und den Ruhestrom des zweiten Endverstärkers (M2) einstellt.

2.   Verstärker nach Anspruch 1, **dadurch gekennzeichnet, dass** der erste und zweite Vorverstärkerblock (N1B, N2B) Röhren und/oder Halbleiter enthält und die ausgangsseitige Spannungsanpassung an den ersten und zweiten Endverstärker (M1, M2) mittels des zugeordneten ersten und zweiten Potentialdifferenzerzeugers (4, 5) in Verbindung mit der Ruhestromeinstelleinrichtung (Ix) erfolgt.

3.   Verstärker nach Anspruch 2, **dadurch gekennzeichnet, dass** zusätzlich zu dem ersten und zweiten Verstärkerblock (N1B, N2B) eine Regeleinrichtung (B1) in Abhängigkeit von den Offsetspannungen an dem ersten und zweiten Ausgang (RL1, RL2) Korrektursignale (bias2, bias1) dem ersten und/oder zweiten Verstärkerblock (N1B, N2B) zuführt und damit Offsetspannungen an dem ersten und zweiten Ausgang (RL1, RL2) beseitigt oder zumindest verkleinert.

4. Verstärker nach Anspruch 3, **dadurch gekennzeichnet, dass** die Regeleinrichtung (B1) eine erste Regeleinheit (B2) enthält, der als Istwert ein von den Gleichspannungsarbeitspunkten des ersten und zweiten Ausgangs (RL1, RL2) abhängiges Signal (avg) und als Sollwert ein vorgegebener Gleichspannungspegel (V5) zugeführt sind.

5. Verstärker nach Anspruch 3 oder 4, **dadurch gekennzeichnet, dass** die Regeleinrichtung (B1) eine zweite Regeleinheit (B3) enthält, der als Istwert die Spannungsdifferenz (diff) zwischen dem ersten und zweiten Ausgang (RL1, RL2) zugeführt ist, wobei als Sollwert der Spannungsdifferenz-Nullwert dient.

6. Verstärker nach Anspruch 5, **dadurch gekennzeichnet, dass** die Regeleinrichtung (B1) eine dritte Regeleinheit (B4) enthält, so dass der vorgegebene Gleichspannungspegel mittels einer Filtereinrichtung aus dem Potentialmittelwert des ersten und zweiten Eingangs (+in, -in) gebildet ist.

7. Verstärker nach Anspruch 5, **dadurch gekennzeichnet, dass** der vorgegebene Gleichspannungspegel für die erste Regeleinheit (B2) mittels einer Filtereinrichtung (R26, C3) aus dem Potentialmittelwert (avgin) derjenigen Eingänge des ersten und zweiten Vorverstärkerblocks (N1 B, N2B) gebildet ist, die jeweils über ein Gegenkopplungsnetzwerk mit dem ersten bzw. zweiten Ausgang (RL1, RL2) verbunden sind.

8. Verstärker nach mindestens einem der Ansprüche 1 bis 7, **dadurch gekennzeichnet, dass** die Ruhestromeinstelleinrichtung (Ix) den Ruhestrom für den ersten und zweiten Endverstärker (M1, M2) mittels eines temperaturabhängigen Steuerwerts einstellt, wobei die Temperatur insbesondere im Bereich der Endverstärker bestimmt ist.

9. Verstärker nach mindestens einem der Ansprüche 1 bis 7, **dadurch gekennzeichnet, dass** die Ruhestromeinstelleinrichtung (Ix) einen Regler enthält, der den Istwert des Ruhestroms mindestens eines Endverstärkers (M1, M2) misst und auf einen Sollwert nachregelt.

10. Verstärker nach mindestens einem der Ansprüche 1 bis 8, **dadurch gekennzeichnet, dass** lokale Gegenkopplungen und/oder Kompensationsmaßnahmen in den beiden Signalpfaden der Verbesserung des linearen Obertragungsverhaltens dienen.

## Claims

1. Amplifier realised as a symmetrical push-pull version having a first amplifying device and a similar second amplifying device whereat the first amplifying device (N1B, M1) is connected in a first signal path between a first input (+in) and a first output (RL1) and a second amplifying device (N2B, M2) is connected in a second signal path between a second input (-in) and a second output (RL2), furthermore a signal which should be amplified could be connected to the first input and/or to the second input (+in, -in) and an external connectable load (RL) could be connected to the first and second output (RL1, RL2),

    - the first input (+in) is coupled to the signal input of a first preamplifying block (N1B), which is feeded by a voltage supply device (V3, V4), and whose output is coupled to the signal input of a first final amplifier (M1) and the second input (-in) is coupled to the signal input of a second preamplifying block (N2B), which is feeded by a voltage supply device (V3, V4), and whose output is coupled to the signal input of a second final amplifier (M2);
    - the first final amplifier (M1) is supplied by a first floating voltage supply (V1) and the second final amplifier (M2) is supplied by a second floating voltage supply (V2);
    - the first final amplifier (M1) is connected via its first supply terminal to one terminal of the first voltage supply (V1) and via its second supply terminal, which is used as an output of the final amplifier too, to the first output (RL1) und via the load (RL) to the other terminal of the first voltage supply (V1), and
    - the second final amplifier (M2) is connected via its first supply terminal to one terminal of the second voltage supply (V2) and via its second supply terminal, which is used as an output of the final amplifier too, to the second output (RL2) und via the load (RL) to the other terminal of the second voltage supply (V2),

    **characterized in that**

    - a first generator of potential difference (4) between the output of the first preamplifier block (N1 B) and the first output (RL1) produces, dependent on the quiescent current control device (Ix), a first difference voltage between the output of the first preamplifier block (N 1 B) and the first output (RL1) which determines the working point and the quiescent current of the first final amplifier (M1) and

- a second generator of potential difference (5) between the output of the second preamplifier block (N2B) and the second output (RL2) produces, dependent on the quiescent current control device (Ix), a second difference voltage between the output of the second preamplifier block (N2B) and the second output (RL2) which sets the working point and the quiescent current of the second final amplifier (M2).

2. Amplifier in accordance with claim 1, **characterized in that** the first and second preamplifier block (N1 B, N2B) comprise electron tubes and/or semiconductors and on the output side the voltage alignment to the first and second final amplifier (M1, M2) is done by means of the first and second generator of potential differences (4, 5) respectively in conjunction with the quiescent current control device (Ix).

3. Amplifier in accordance with claim 2, **characterized in that** additional to the first and second preamplifier block (N1 B, N2B) a regulating device (B1) dependent on the offset voltages at the first and second output (RL1, RL2) applies correction signals (bias2, bias1) to the first and/or second preamplifier block (N1B, N2B) and therewith said regulating device (B1) eliminates or at least reduces offset voltages at the first and second output (RL1, RL2).

4. Amplifier in accordance with claim 3, **characterized in that** the regulating device (B1) comprises a first regulating entity (B2) to which as actual value a signal (avg), dependent on the direct current voltage of the working points of first and second output (RL1, RL2), and as desired value a predetermined direct current voltage level (V5) are applied.

5. Amplifier in accordance with claim 3 or 4, **characterized in that** the regulating device (B1) comprises a second regulating entity (B3) to which as actual value the voltage-difference (diff) between the first and second output (RL1, RL2) is applied whereat the zero value of the voltage-difference acts as predetermined value.

6. Amplifier in accordance with claim 5, **characterized in that** the regulating device (B1) comprises a third regulating entity (B4), so that the predetermined direct current voltage level is composed of the average potential value of the first and second input (+in, -in) by means of a filter device.

7. Amplifier in accordance with claim 5, **characterized in that** the predetermined direct current voltage level of the first regulating entity (B2) is composed, by means of a filter device (R26, C3), of the average potential value (avgin) of those inputs of the first and second preamplifier blocks (N1B, N2B) which are each connected via a feedback network with the first and second output (RL1, RL2) respectively.

8. Amplifier in accordance with at least one of the claims 1 to 7, **characterized in that** the quiescent current control device (Ix) sets the quiescent current of the first and second final amplifier (M1, M2) by means of a temperature dependent control value in which the temperature is especially provided in the area of the final amplifier.

9. Amplifier in accordance with at least one of the claims 1 to 7, **characterized in that** the quiescent current control device (Ix) comprises a regulator which measures the actual value of the quiescent current of at least one final amplifier (M1, M2) and readjusts the quiescent current to a desired value.

10. Amplifier in accordance with at least one of the claims 1 to 8, **characterized in that** local feedback and/or compensation methods in both signal chains are applied to enhance the linear transmission behavior.

**Revendications**

1. Amplificateur dans une version en push-pull symétrique comprenant un premier dispositif d'amplification et un second dispositif d'amplification identique au premier, le premier dispositif d'amplification (N1B, M1) étant raccordé dans un premier chemin de signal entre une première entrée (+in) et une première sortie (RL1), et un second dispositif d'amplification (N2B, M2) étant raccordé dans un second chemin de signal entre une seconde entrée (-in) et une seconde sortie (RL2), et également un signal à amplifier peut être raccordé à la première et/ou à la seconde entrée (+in, -in) et une charge (RL) à raccorder de façon externe peut être raccordée à la première et à la seconde sorties (RL1, RL2),

- la première entrée (+in) est couplée avec l'entrée de signal d'un premier bloc préamplificateur (N1B) alimenté par un dispositif d'alimentation en tension (V3, V4) et sa sortie est couplée avec l'entrée de signal d'un premier amplificateur final (M1), et la seconde entrée (-in) est couplée avec l'entrée de signal d'un second bloc préamplificateur (N2B) alimenté par le dispositif d'alimentation en tension (V3, V4) et sa sortie est couplée avec l'entrée de signal d'un second amplificateur final (M2),

- le premier amplificateur final (M1) est alimenté par une première source de tension (V1) flottante et le second amplificateur final (M2) est alimenté par une seconde source de tension (V2) flottante,
- le premier amplificateur final (M1) est relié par son premier branchement d'alimentation à un pôle de la première source de tension (V1) et par son second branchement d'alimentation, qui sert également de sortie d'amplificateur final, à la première sortie (RL1) et par la charge (RL) à l'autre pôle de la première source de tension (V1), et
- le second amplificateur final (M2) est relié par son premier branchement d'alimentation à un pôle de la seconde source de tension (V2) et par son second branchement d'alimentation, qui sert également de sortie d'amplificateur final, à la seconde sortie (RL2) et par la charge (RL) à l'autre pôle de la seconde source de tension (V2),

**caractérisé en ce que**,

- un premier générateur de différence de potentiel (4) entre la sortie du premier bloc préamplificateur (N1B) et la première sortie (RL1) génère en fonction d'un dispositif de réglage de courant de repos (Ix) une première tension différentielle entre la sortie du premier bloc préamplificateur (N1B) et la première sortie (RL1), qui détermine le point de travail et le courant de repos du premier amplificateur final (M1), et
- un second générateur de différence de potentiel (5) entre la sortie du second bloc préamplificateur (N2B) et la seconde sortie (RL2) génère en fonction du dispositif de réglage de courant de repos (Ix) une seconde tension différentielle entre la sortie du second bloc préamplificateur (N2B) et la seconde sortie (RL2), qui règle le point de travail et le courant de repos du second amplificateur final (M2).

2. Amplificateur selon la revendication 1, **caractérisé en ce que** le premier et le second bloc préamplificateur (N1B, N2B) contiennent des tubes et/ou des semi-conducteurs et l'adaptation de tension côté sortie au premier et au second amplificateur final (M1, M2) s'effectue au moyen du premier et du second générateurs de différence de potentiel (4, 5) attribués en liaison avec le dispositif de réglage du courant de repos (Ix).

3. Amplificateur selon la revendication 2, **caractérisé en ce que**, en supplément du premier et du second bloc amplificateur (N1B, N2B), un dispositif de réglage (B1) amène en fonction des tensions de décalage sur la première et la seconde sortie (RL1, RL2) des signaux de correction (bias2, bias1) au premier et/ou au second bloc amplificateur (N1B, N2B) et élimine ou tout au moins réduit ainsi des tensions de décalage sur la première et la seconde sortie (RL1, RL2).

4. Amplificateur selon la revendication 3, **caractérisé en ce que** le dispositif de réglage (B1) contient une première unité de réglage (B2) à laquelle sont amenés comme valeur réelle un signal (avg) dépendant des points de travail de tension continue de la première et de la seconde sortie (RL1, RL2) et comme valeur prescrite un niveau de tension continu prédéfini (V5).

5. Amplificateur selon la revendication 3 ou 4, **caractérisé en ce que** le dispositif de réglage (B1) contient une seconde unité de réglage (B3) , à laquelle est amenée comme valeur réelle la différence de tension (diff) entre la première sortie et la seconde sortie (RL1, RL2), la valeur zéro de différence de tension servant de valeur prescrite.

6. Amplificateur selon la revendication 5, **caractérisé en ce que** le dispositif de réglage (B1) contient une troisième unité de réglage (B4), de sorte que le niveau de tension continue prédéfini est formé au moyen d'un dispositif de filtre à partir de la valeur moyenne de potentiel de la première et de la seconde entrée (+in, - in).

7. Amplificateur selon la revendication 5, **caractérisé en ce que** le niveau de tension continue prédéfini pour la première unité de réglage (B2) est formé au moyen d'un dispositif de filtre (R26, C3) à partir de la valeur moyenne de potentiel (avgin) des entrées respectives du premier et du second bloc préamplificateur (N1B, N2B) qui sont reliées chacune au moyen d'un réseau de contre-couplage à la première ou à la seconde sortie (RL1, RL2).

8. Préamplificateur selon au moins une quelconque des revendications 1 à 7, **caractérisé en ce que** le dispositif de réglage du courant de repos (Ix) règle le courant de repos pour le premier et le second préamplificateur final (M1, M2) au moyen d'une valeur de commande dépendante de la température, la température étant déterminée en particulier dans la zone des amplificateurs finals.

9. Amplificateur selon au moins l'une quelconque des revendications 1 à 7, **caractérisé en ce que** le dispositif de réglage du courant de repos (Ix) contient un régulateur qui mesure la valeur réelle du courant de repos d'au moins un amplificateur final (M1, M2) et la règle ultérieurement sur une valeur prescrite.

10. Amplificateur selon au moins l'une quelconque des revendications 1 à 8, **caractérisé en ce que** des contre-couplages locaux et/ou des mesurés de compensation servent dans les deux chemins de signal à l'amélioration du comportement linéaire à la transmission.

Fig. 1

Stand der Technik

Fig. 2

Stand der Technik

EP 1 548 934 B1

Fig. 3

Stand der Technik

Fig. 4

Fig. 5

Fig. 6

Fig. 7

Fig. 8

Fig. 9

Fig. 10

Verstärker

Biasregelung

EP 1 548 934 B1

Fig. 11

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5892398 A
- US 4719431 A

- US 6242977 B1
- US 4229706 A

**In der Beschreibung aufgeführte Nicht-Patentliteratur**

- **H. LEMME.** *Elektronik,* Oktober 2003, 90-94